(19) **Europäisches Patentamt / European Patent Office / Office européen des brevets**

(11) **EP 3 505 859 A1**

(12) **EUROPEAN PATENT APPLICATION**

(43) Date of publication:
03.07.2019 Bulletin 2019/27

(51) Int Cl.:
*F28D 21/00* (2006.01)      *F28D 7/16* (2006.01)
*F28D 9/00* (2006.01)      *F01N 5/02* (2006.01)
*F28F 9/04* (2006.01)

(21) Application number: 17382903.7

(22) Date of filing: 26.12.2017

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
MA MD TN

(71) Applicant: BORGWARNER EMISSIONS SYSTEMS
SPAIN, S.L.U.
36315 Vigo Pontevedra (ES)

(72) Inventors:
• HERMIDA DOMÍNGUEZ, Xoan Xosé
E-36380 Gondomar, Pontevedra (ES)

• GONZÁLEZ TABARÉS, Iago
E-36202 Vigo, Pontevedra (ES)
• PÉREZ MAURICIO, Xurxo
E-36206 Vigo, Pontevedra (ES)
• SIMO, Gonzalo
E-36206 Vigo, Pontevedra (ES)
• CARNERO LÓPEZ, César
E-36203 Vigo, Pontevedra (ES)
• VIDAL, Ignacio
E-36315 Vigo, Pontevedra (ES)

(74) Representative: ABG Intellectual Property, S.L.
Avenida de Burgos, 16D
Edificio Euromor
28036 Madrid (ES)

(54) **RECUPERATOR DEVICE FOR RECOVERING ENERGY FROM EXHAUST GAS HEAT**

(57)      The present invention is a device for recovering energy from exhaust gas heat of an internal combustion engine. Particularly, the invention relates to a recuperator device which makes use of a temperature gradient between two conduits to generate an electric potential by means of a plurality of thermoelectric boards.

Fig.8

EP 3 505 859 A1

**Description**

Object of the Invention

The present invention is a device for recovering energy from exhaust gas heat of an internal combustion engine. Particularly, the invention relates to a specific configuration of a recuperator device which utilizes a temperature gradient between two conduits at different temperatures to generate an electric potential by means of a plurality of thermoelectric boards.

Background of the Invention

One of the fields of the art that has been subjected to the most intensive development is the field of energy recovery systems in vehicles with internal combustion engines. Internal combustion engines generate a large amount of residual heat which is usually evacuated into the atmosphere through exhaust gases, resulting in a failure to utilize the energy in form of heat and in an increase in pollution.

It is estimated that about two-thirds of the combustion energy in current vehicles is evacuated into the atmosphere in the form of exhaust gas heat, so any system which utilizes the residual heat will be recovering energy that would otherwise be lost.

Energy recovery devices transferring exhaust gas heat to another fluid coolant which is subsequently used, for example, for regeneration or air conditioning are known. However, the relatively low temperature of the recovered heat prevents it from being able to be used as a hot source in most thermodynamic cycles for electric energy generation; furthermore this option requires using large volume, heavy and expensive devices.

Additionally, the use of thermoelectric elements for generating electric energy directly from a temperature difference between two sources, a source identified as a cold source and another source identified as a hot source, utilizing the so-called Seebeck effect characteristic of some materials, is known in the field of the art.

A thermoelectric element is a junction of at least two materials, generally semiconductors, having features such that they produce an electron flow in the presence of a temperature gradient. To obtain a good thermoelectric material, the selected materials must combine high electrical conductivity and low thermal conductivity to maintain the temperature gradient, being two properties that do not tend to be present simultaneously in the materials. Today, nanotechnology has opened up doors to new semiconductor materials with a reduced thermal conductivity and excellent electrical conductivity properties.

First, it will be necessary to describe the basis of the thermoelectric effect which allows direct conversion of temperature to voltage and vice versa, and as a result can be used for generating electricity, measuring temperatures, heating or cooling objects, etc. In the present field of the art, it is advantageous to apply the thermoelectric effect for generating a potential difference from a temperature gradient or difference, for which the use of a thermal electric generator (TEG) module will be required.

The thermoelectric effect occurs due to the flow of electrons generating a voltage as they move from the hot side to the cold side of a TEG module. At the atomic scale, it is observed that a temperature difference causes charge carriers of the material to move, as a result of density difference, from the most-charged areas to areas with electron holes. Particularly, two phenomena describing opposite aspects of the thermoelectric effect are distinguished: the Seebeck effect and Peltier effect.

In the Seebeck effect, it is observed that when there is a temperature difference at the junction points of two different metals, a voltage appears, since the metals respond differently to the changes in temperature.

The Peltier effect and constitutes a case that is opposite to that of Seebeck effect, since the temperature variation generated when applying a voltage to two metals or semiconductors that are connected by two "Peltier junctions" is observed. The efficiency of these thermoelectric materials is governed by their "dimensionless figure of merit" ZT, and to have a good thermoelectric efficiency, the figure of merit must be as large as possible.

$$ZT = \frac{\alpha^2 \cdot \sigma}{\kappa} \cdot T;$$

where:

$\alpha$: Seebeck coefficient,
$\sigma$: electrical conductivity,
$k$: thermal conductivity,
$T$: temperature.

As described above, thermoelectric materials are those having the capacity to convert thermal energy into electric energy according to the Seebeck effect, or conversely, to convert electric energy into a thermal difference, following the Peltier effect.

Thermoelectric modules or TEG modules are groups of thermoelectric materials arranged in the form of circuits, shaped from P-type (positive) and N-type (negative) materials.

Alternatively, a thermoelectric module can work as a heat or cold generator when a potential difference is applied thereto, working according to the Peltier effect. It is therefore also possible to couple a thermoelectric module to a air conditioning system of a vehicle and to produce with it cold or heat according to its polarization.

Returning to energy recovery devices in vehicle exhaust systems, another possible application of thermoelectric materials is precisely the use of thermoelectric modules as a recuperator device for recovering energy from exhaust gases.

For that end, it is advantageous to provide a PCB (printed circuit board) with a plurality of connected thermoelectric modules, forming a circuit and working as electric generators which could charge batteries or supply electricity to any component of a vehicle.

This would allow equipping the vehicle with a less powerful alternator that weighs less, or directly dispensing with an alternator which detracts effective output from the combustion engine. Furthermore, in a favorable case the batteries of current hybrid vehicles may be charged with a thermoelectric module and the engine of vehicles with an automatic start-stop system may be started.

These advantages translate into an improvement of engine efficiency and a reduction of vehicle weight, which would lead to reduced fuel consumption, and therefore reduced emissions.

The application of thermoelectric devices in applications of this type has, however, a series of technological challenges that were not able to be solved satisfactorily to date. Particularly, the assembly of a thermoelectric device in a heat exchanger is subjected to thermal stresses and high temperatures of the exhaust gases. Device efficiency is achieved with a stack of groups of tubes and boards with thermoelectric modules, where each group contains tubes which are cold in the operative mode, the thermoelectric module or modules and tubes which are hot in the operative mode. In this stack, the close contact between the tubes constituting the cold or hot source and the thermoelectric module or modules must be maintained to assure the correct operation of the thermoelectric module or modules. Any dimensional defect or assembly defect will prevent obtaining a device with the desired close contact after said assembly.

Description of the Invention

The present invention proposes a solution to the technical problems of the application of thermoelectric devices in energy recovery systems for vehicles equipped with internal combustion engines. Particularly, the present invention proposes a solution which allows arranging a plurality of thermoelectric modules between a tube bundle of the energy recovery device, such that a good thermal contact between the thermoelectric modules and the tubes is assured, and at the same time the assembly can be performed in an efficient and automatable manner.

In a first inventive aspect, the present invention proposes a *recuperator for recovering energy from exhaust gas heat of an internal combustion engine, there being a first hot fluid, i.e., the exhaust gas, and a second cold fluid, i.e., a liquid coolant, wherein the recuperator comprises*:

- *at least a first inlet baffle and a first outlet baffle for the first fluid and a second inlet baffle and a second outlet baffle for the second fluid, wherein each of the*

*baffles comprises openings for the passage of the corresponding fluid;*
- *a first tube bundle for the passage of the first fluid, wherein these tubes:*

  *are arranged essentially parallel to one another and, the tubes of the first tube bundle extend from the first inlet baffle to the first outlet baffle;*

- *a second tube bundle for the passage of the second fluid, wherein these tubes:*

  *are arranged essentially parallel to one another and, the tubes of the second tube bundle extend from the second inlet baffle to the second outlet baffle;*

- *a plurality of thermoelectric modules comprising a first face and a second face arranged opposite the first face, wherein the thermoelectric modules are adapted for generating an electric potential based on a temperature gradient between the first face and the second face;*

*wherein the first tube bundle, the second tube bundle and the plurality of thermoelectric modules form a stack such that each thermoelectric module has the first face in thermal contact with a tube of the first tube bundle the second face in thermal contact with a tube of the second tube bundle;*
*characterized in that*
*the tubes of the first tube bundle, the tubes of the second tube bundle, or both, comprise a support element at each end of the tube adapted for being supported on a face of the baffle corresponding to said end of the tube and establishing a fluid communication through one or more openings of the baffle between the inside of the tube and the side of the baffle arranged on the side opposite the tube.*

The energy recovery device described according to a first aspect of the invention allows recovering energy from exhaust gas heat of a vehicle by means of the conversion thereof into electric energy. To convert heat into a potential difference, the recuperator for recovering energy uses thermoelectric modules arranged between tubes containing a hot fluid and tubes containing a cold fluid or coolant at a lower temperature than the hot fluid, such that there is a thermal gap between both fluids. Advantageously, the device described by the present invention allows establishing a better thermal contact between both faces of the thermoelectric modules and the corresponding tubes, and at the same time making assembly easier and assuring leaktightness.

In a preferred embodiment, the attachment between each support element and the baffle is leak-tight. The coolant, or the hot fluid, or both are therefore prevented from leaking out of the tubes in which they are confined, causing damage on the recuperator itself or on other surrounding elements.

The support element can be possibly be configured as an element extending perimetrically around the tube, such that it makes attachment with the baffle easier. This is particularly advantageous for assuring a leak-tight attachment between the tube and the baffle.

The invention solves the technical problem by establishing a relative positioning between the tubes and the baffle such that they are suitably positioned before being attached to one another, and at the same time allowing relative movement between the elements of the stack to allow for compaction by applying pressure on said stack.

Even when there are small dimensional errors in any of the elements making up the stack, for example, the thickness of the tubes, the thickness of the thermoelectric modules, the lack of flatness, the support element at the end of the tube on the baffle assures the correct relative positioning between the tube and the baffle while allowing sliding between said support element and said baffle. In other words, once the stack is configured and all the components of the recuperator for recovering energy are placed in position, according to a preferred example of the invention a compaction force can be applied on the stack assuring the close contact which assures the thermal contact between the tubes and the thermoelectric modules. The compaction force is effective because it enables the relative sliding of the support element on the face of the baffle on which it is supported and allows for the components of the stack to be in place until the correct compaction is assured.

The tube and the baffle on which the support element is supported are attached to one another in this position in which the stack is compacted. A second aspect of the invention relates to a construction method for constructing the recuperator for recovering energy from elements of the recuperator for recovering heat according to the first aspect of the invention in which the sequence of first forming the stack in conditions such that thermal contact between components of the stack is assured, and subsequently attaching the support elements, assure that said thermal contact is maintained in the device thus manufactured.

According to the preferred example, the conditions assuring the thermal contact comprise the application of a compaction force on the stack before and during the attachment of each of the support elements to the baffle on which it is supported.

In a particular embodiment, as a way to contain the recuperator, the recuperator comprises a shell which in another particular embodiment further comprises a plurality of springs arranged between the shell and the stack and adapted for applying a compressive force on said stack. A suitable thermal contact between the thermoelectric modules and the tubes is achieved by means of this compressive force. Furthermore, it provides the invention with the additional advantage of the tubes and thermoelectric modules being kept in the desired position during construction of the recuperator.

In a particular embodiment, either the tubes of the first tube bundle have a longitudinal configuration and the tubes of the second tube bundle have a U-shaped configuration or the tubes of the second tube bundle have a longitudinal configuration and the tubes of the first tube bundle have a U-shaped configuration. It will be understood herein that the U-shaped configuration corresponds to an arrangement of the tubes with a change in direction, such that at least the direction of movement of the fluid at the outlet end of the tube changes with respect to the direction of movement of the fluid at the inlet end of the tube, i.e., the direction of exit being opposite to the direction of entry. This configuration has the advantage of allowing a compact arrangement of the recuperator for recovering energy. According to another particular embodiment, the tubes of the first tube bundle are transverse to the tubes of the second tube bundle.

According to a particular embodiment, the tubes of the first tube bundle, or the tubes of the second tube bundle, or both are flat, such that a set of tubes can be stacked one on top of another on their flat sides, giving rise to a compact assembly with a large heat exchange surface. In one embodiment, both the tubes of the first tube bundle and the tubes of the second tube bundle are flat and have comparable dimensions, such that they allow the thermoelectric modules to be sandwiched therebetween, maximizing the heat exchange surface, and forming a compact assembly.

According to an embodiment, the heat exchange tubes have a specific configuration with two parallel conduits, with independent inlets and outlets, and which are structurally attached to one another. This results in a composite tube which has a great width, high resistance and allows easy manufacture. Furthermore, each conduit of the composite tube has the approximate dimensions of a thermoelectric module, such that a better thermal contact between the thermoelectric modules and the heat exchange tubes is established.

In another embodiment of the invention, there is a thermal insulation material between a thermoelectric module and the tube with which it is in thermal contact. This type of material allows maintaining the temperature gradient between both faces of the thermoelectric module, protecting the thermoelectric module and homogenizing the temperature on the face where contact between surfaces occurs. According to a particular embodiment, the thermal insulation material in contact with the first face of a thermoelectric module is graphite. In another particular embodiment, the thermal insulation material in contact with the second face of a thermoelectric module is silicone. The two preceding embodiments are compatible with one another and their combined use is advantageous for protecting the thermoelectric modules and maintaining the temperature gradient as will be described in the detailed description of the invention. Advantageously, silicone, or a material containing it, allows homogenizing temperature distribution in the contact region between the tube and the module.

Additionally, the device verifies that a plurality of thermoelectric modules in the stack are grouped together on boards having a flat configuration. In one embodiment, this board is a printed circuit board or PCB which comprises the thermoelectric modules with their corresponding electrical connections, as well as part of or all the elements required for electric energy conversion. Printed circuit boards are particularly advantageous due to their ease of manufacture and essentially flat configuration, making their assembly between the tube bundles described above easier.

An embodiment in which one or more baffles are attached to a manifold is also contemplated; this embodiment allows establishing a fluid communication between the tubes of the first tube bundle, or the tubes of the second tube bundle, or both and one of the manifolds. Each of said manifolds is predictably attached either to a conduit transporting the exhaust gases of an engine if it belongs to the hot fluid circuit, or to a cooling circuit if it belongs to the cold fluid circuit. The attachment between the baffles and the manifolds in a particular way of constructing the device is welded by means of laser welding.

As a way to make leak-tight attachment between the baffles and the support elements easier, in a preferred embodiment the support element is a plate transverse to the tube. This configuration increases the support area, i.e., the contact area, between both elements and makes the application of means forming a leak-tight attachment easier, for example, the welding of the plate transverse to the baffle or the application of an adhesive between said elements. Furthermore, in a particular embodiment the plate transverse to the tube is a prolongation of the tube, such that the transverse plate is easily manufactured, for example, by means of an operation of stamping or forming from the tube itself as a hydroforming spring.

Additionally, as indicated above the invention according to a second aspect of the invention verifies a construction method for constructing a recuperator for recovering energy like the one described above, which method *comprises the steps of:*

*a) providing a support element at each end of the tube adapted for being supported on a face of the baffle corresponding to said end of the tube;*
*b) establishing a stack of the first tube bundle, the second tube bundle and the plurality of thermoelectric modules such that*

- *each thermoelectric module has the first face in thermal contact with a tube of the first tube bundle the second face in thermal contact with a tube of the second tube bundle and,*
- *the support elements are supported on the baffles corresponding to each end of the tube, establishing fluid communication through one or*

*more openings of the baffle between the inside of the tube and the side of the baffle arranged on the side opposite the tube;*

*c) attaching each of the support elements to the baffle on which it is supported.*

The described method allows constructing a energy recovery device in which, after assembling support elements at the ends of the tubes, tube bundles are stacked, with thermoelectric modules being arranged therebetween, such that they are in thermal contact with the tubes in the described manner, and incorporating the baffles to the device, such that they allow, on one hand, fluid communication through the baffle, and on the other hand, the support elements to be in contact with the baffle. The attachment between the support elements and the baffle on which it is supported is then made. In a particular embodiment, this attachment is made by means of a welding.

Unlike the known construction methods, the device described by the present invention for most part of the embodiments is not suitable to be subjected to high temperatures, such as the temperatures in a furnace to perform braze welding, for example, given that the electronic control circuits of the boards with thermoelectric modules would become damage, for example, so the application of laser welding or comparable methods that do not subject the thermoelectric modules to high temperatures which may damage the materials or circuits would be advantageous.

In a particular embodiment of the method, the attachment of each of the support elements to the baffle on which it is supported according to step c) is carried out while a compressive force is applied on the stack. An advantage of this embodiment is that in order to assure a suitable thermal contact between the faces of the thermoelectric modules and the exchange tubes, prior to the step of attaching the support elements to the baffles, the stack of tubes is subjected to a compressive stress in the stacking direction, such that once the attachment is made, the stack maintains the thermal contact between all its components. The application of a compressive stress allows assuring the compaction of the stack and the thermal contact between the components of the stack, even in the presence of defects such as the lack of flatness and other dimensional defects. In another particular embodiment of the method, the attachment of step c) is a leak-tight attachment.

All the features and/or steps of method described in this specification (including the claims, description and drawings) can be combined in any combination, with the exception of those combinations of mutually exclusive features.

Description of the Drawings

The foregoing and other features and advantages of the invention will be more clearly understood based on the following detailed description of a preferred embodiment given only by way of illustrative and non-limiting example in reference to the attached drawings.

Figure 1 is a perspective view of a first preferred embodiment in which the first tube bundle is shown with the tubes supported on their corresponding baffles and without the thermoelectric modules to allow clearly seeing the rest of the components.

Figure 2 is a perspective of the same embodiment in which a view of the stack of the first and second tube bundle is shown with their corresponding baffles and manifolds.

Figure 3 shows a perspective view of the plurality of thermoelectric module boards in their spatial position in the stack according to the same embodiment.

Figure 4 shows a perspective view of a tube of the first tube bundle, together with its corresponding support elements, and its baffle and manifold according to its relative spatial positioning, all of them according to the same embodiment.

Figure 5 shows a perspective view of the stack of tubes of the second tube bundle, together with their corresponding support elements, and their baffle and manifold according to their relative spatial positioning, all of them according to the same embodiment.

Figure 6 shows three views, i.e., a perspective view, a front view and a plan view, of a separate tube of the second tube bundle according to the same embodiment in perspective view.

Figure 7 shows a perspective view of the second tube bundle supported on its corresponding baffles according to the same embodiment.

Figure 8 shows a perspective view of the recuperator for recovering energy according to the same embodiment with a quarter section.

Figure 9 shows an amplified detail of the quarter section shown in the preceding drawing of the recuperator for recovering energy.

Figure 10 shows a still more amplified detail of the preceding drawing in which details of the tube stacks are shown.

Figure 11 shows a detail of a section view of the stack according to an embodiment in which the arrangement of the elements forming it can be seen.

Detailed Description of the Invention

According to the first inventive aspect, the present invention is a recuperator for recovering energy or a device for recovering energy from exhaust gas heat of a vehicle by means of converting same into electric energy. To convert heat into a potential difference, the recuperator for recovering energy uses a plurality of thermoelectric modules (7.1) arranged between tubes (3) containing a hot fluid and tubes (6) containing a cold fluid or coolant.

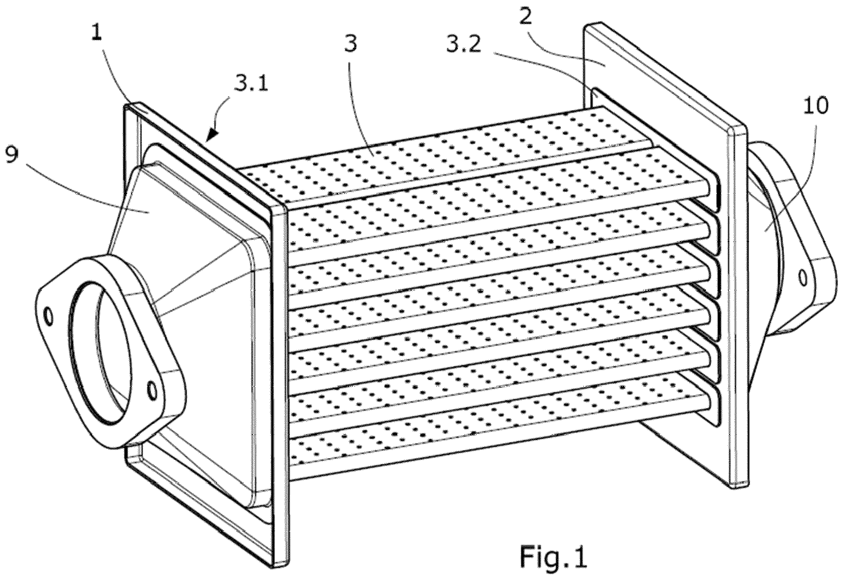

Figure 1 shows an embodiment of the invention in which a first inlet baffle (1), a first outlet baffle (2), a first tube bundle (3) extending between the first inlet baffle (1) and the first outlet baffle (2), a first inlet manifold (9) for distributing hot gas into the inlets of the tubes of the first tube bundle (3) and a first outlet manifold (10) receiving the hot gas after it exits the same first tube bundle (3) can be seen.

This perspective view also shows support elements (3.1, 3.2) located at the ends of the tubes of the first tube bundle (3) in contact with the first baffles (1, 2), and a free space which is located between the tubes of the first tube bundle (3) that are arranged in a stack. It is indicated that the arrangement shown in this drawing is a stack arrangement because the view corresponds to the spatial position of the tubes of the first tube bundle (3) without graphically depicting the rest of the elements in order to more clearly see the separation of the support elements (3.1, 3.2).

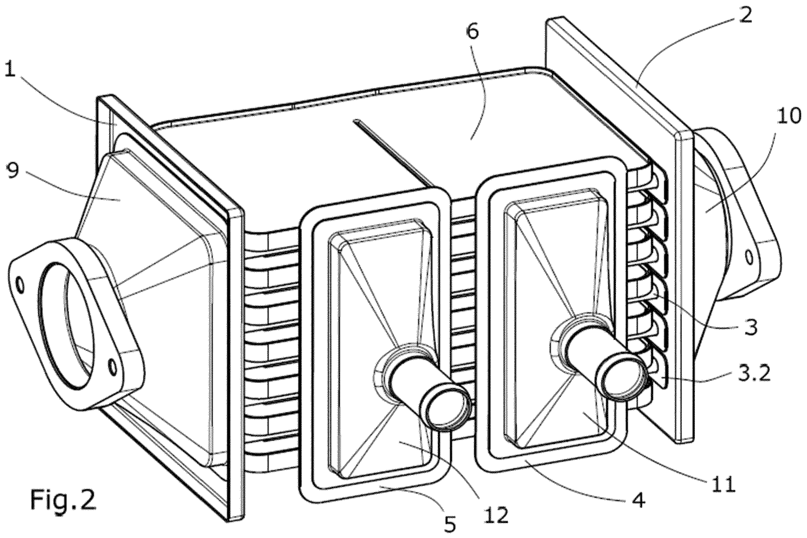

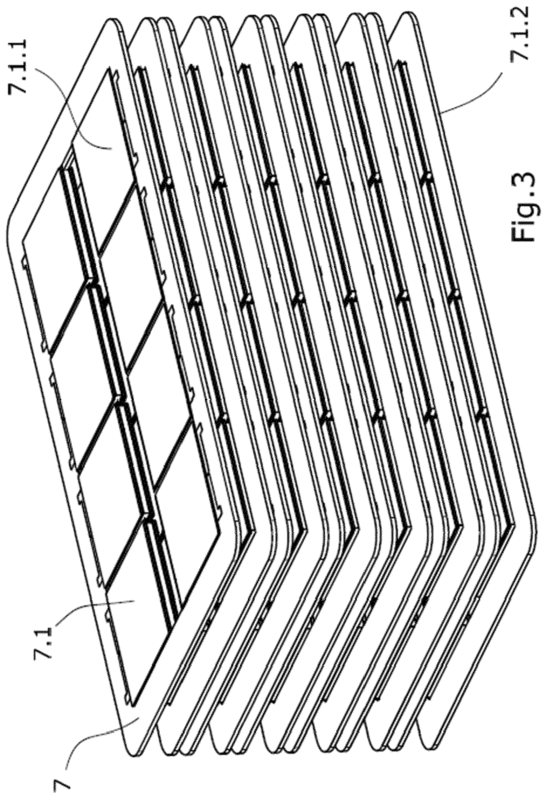

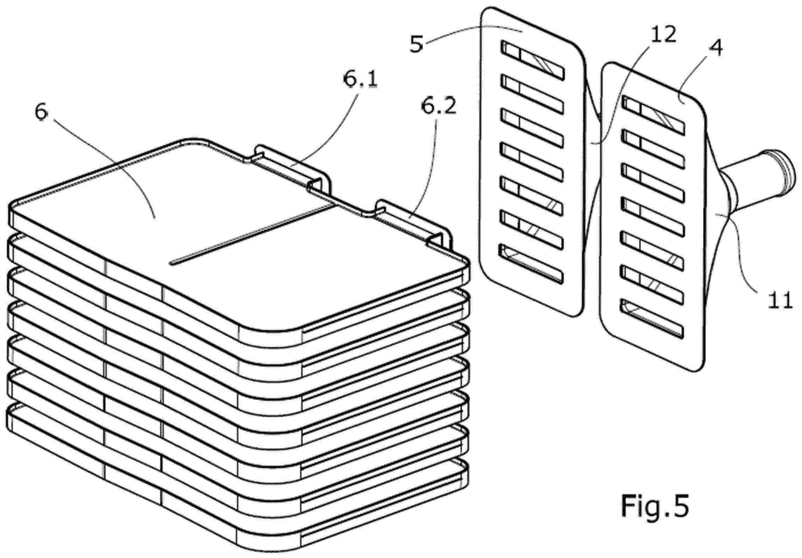

The tubes of a second tube bundle (6) arranged in an alternating manner with respect to the tubes of the first tube bundle (3), and all of them arranged in a stack, have been added to the graphical depiction of the preceding elements in Figure 2. A second inlet baffle (4) and a second outlet baffle (5) are also shown along with corresponding second manifolds (11, 12) for the fluid coolant: a second inlet manifold (11) for distributing liquid coolant into the inlet of the tubes of the second tube bundle (6) and a second outlet manifold (12) for receiving the liquid coolant that exits the tubes of the second tube bundle (6). Neither the support elements of the second tube bundle (6.1, 6.2) (which are indeed shown in Figure 5) nor the thermoelectric modules (shown in Figure 3) can be seen in this view.

Figure 3 depicts a plurality of boards (7) having a flat configuration, this plurality of boards (7) being spatially distributed like how they are placed inside the stack. Each board (7) having a flat configuration comprises a plurality of individual thermoelectric modules (7.1) which, in the shown embodiment, are arranged in two rows such that the number of thermoelectric modules (7.1) installed in the available space is maximized.

The thermoelectric modules (7.1) are the minimum individual element capable of producing a potential difference that can be utilized, and comprises a first face (7.1.1), a second face (7.1.2) and at least two electric terminals; depending on the polarity of the thermoelectric module (7.1), one of the faces is placed in thermal contact with a hot source, and the other face is placed in thermal contact with a cold source. A potential difference is thereby generated between the electric terminals as a result of thermoelectric effect. In the shown embodiment, the board (7) corresponds to a printed circuit board (PCB) comprising electrical connections between the thermoelectric modules (7.1), such that they are connected to one another, and means for converting the type of current generated.

This spatial distribution of the thermoelectric modules (7.1) on a board (7) results in a part configured in the form of a board with two large surfaces, one intended for being in thermal contact with a cold source and another intended for being in thermal contact with a hot source, generating enough potential in connectors which allow extracting electric energy in a utilizable manner.

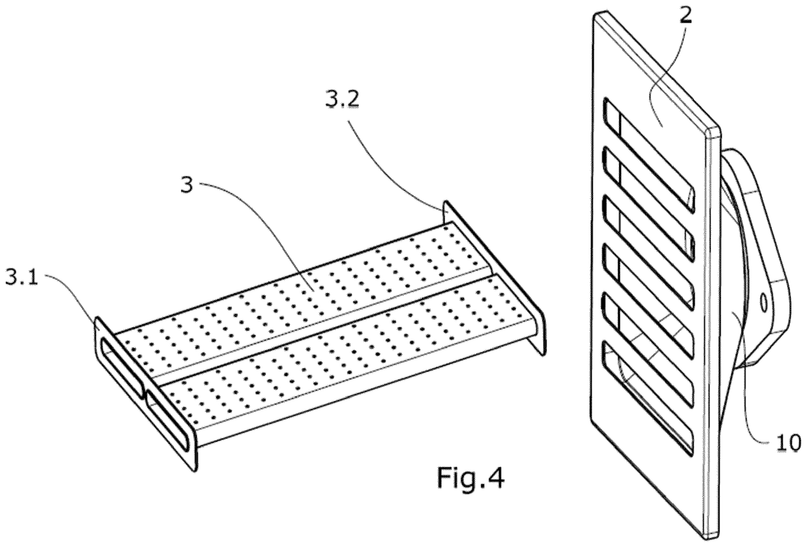

Figures 4 and 5 depict two assemblies of parts, one assembly of parts being associated with the first fluid (Figure 4), i.e., the hot gas, and one assembly of parts being associated with the second fluid (Figure 5), i.e., the liquid coolant; said assemblies of parts comprising baffles, tube bundles, manifolds and support elements. In the case of Figure 4, only a double tube for the first fluid has been graphically depicted.

Figure 4 shows in detail a tube of the first tube bundle (3) with a flat configuration and having, in this embodiment, two separate conduits of rectangular section with the shortest sides being rounded. These tubes (3) are made by means of known methods. A support element (3.1, 3.2) configured as a plate transverse to the tube is located at each end of the tube. In this embodiment, the support elements (3.1, 3.2) furthermore have the function of serving as a structural support and attaching the two conduits of the tube (3) to one another.

The same Figure 4 furthermore shows the first outlet baffle (2) and the first outlet manifold (10). Neither the inlet baffle (1) nor the inlet manifold (9) is shown in this view in order to allow better viewing the shown components which, in this embodiment, would comprise the elements shown in Figures 1 and 2, where they are essentially the same as the outlet elements. The first outlet baffle (2) has a plurality of openings with an almost rectangular section, wherein one of the purposes thereof is to establish fluid communication between the conduits of the tubes (3) and the manifolds (9, 10). In turn, the manifolds (9, 10) are attached in a leak-tight manner to the baffles.

The function of the support elements (3.1, 3.2) is to link each end of the tube (3) with the corresponding baffle (1, 2). As described in the construction method, the attachment between the support elements (3.1, 3.2) and the baffles (1, 2) is initially a support which assures the position between the tube and the baffle with respect to the axial direction defined at the end of the tube while allowing sliding in any of the directions of the plane defined by the baffle (1, 2), and a permanent attachment is made in subsequent steps of the construction method. The degrees of freedom established by the relative sliding between the baffle and the ends of the tubes as a result of the support elements (3.1, 3.2) assure that there is a suitable thermal contact between the tubes and the thermoelectric modules (7.1) when making the attachment between said support elements (3.1, 3.2) and the baffle (1, 2).

It is advantageous for the attachment between the support elements (3.1, 3.2) and the baffles (1, 2) to be leak-tight, since the fluids contained in the tubes (3, 6) will therefore be prevented from leaking out, where it may cause damage to other elements. In this embodiment, the leak-tight attachment is achieved by extending the welding between the support elements (3.1, 3.2) and the baffles (1, 2) to the entire perimetral area of the support elements (3.1, 3.2).

In this embodiment, the support elements (3.1, 3.2) are flat transverse plates (3, 6) rigidly attached to the ends of the tubes (3, 6) by means of welding, for example. According to another embodiment, the support elements (3.1, 3.2) are obtained during the manufacturing process by means of extruding or stamping the same end of the tube (3, 6), for example.

Similarly, the tubes of the second bundle (6), the second baffles (4, 5) and the second manifolds (11, 12) have essentially the same configuration as the assembly described for the first fluid. Figure 5 shows a plurality of tubes of the second tube bundle (6) and their support elements (6.1, 6.2); the tubes (6) have a flat, U-shaped configuration, i.e., the fluid experiencing a 180° change in direction, such that the inlet and the outlet of the second fluid are parallel to one another.

The support elements (6.1, 6.2) for this second tube bundle (6) have the same function as the one described for the first tube bundle (3.1, 3.2).

In the shown embodiment, the recuperator for recovering energy has been configured as a counter-current heat exchanger, but in other embodiments it would also be possible to configure it as a co-current exchanger by interchanging the inlet and the outlet of the assembly of the second fluid.

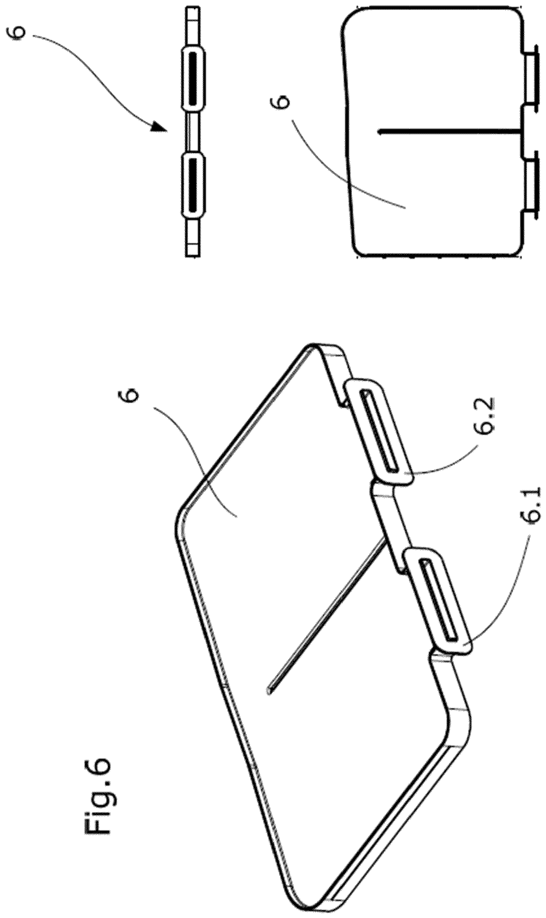

Figure 6 shows a tube of the second tube bundle (6) having a flat configuration and a U-shaped second fluid path or trajectory, with a rectangular section (considering the direction of the fluid path in the conduit). The top view of the tube (6) of this same Figure 6 shows the shape of the tube (6), formed by an essentially rectangular or trapezoidal cavity divided by a divider element into two chambers communicated with one another, and in turn communicating with the outside through the inlet and the outlet, respectively. This conduit configuration allows the fluid to move following a U-shaped trajectory, with the inlet and the outlet on the same lateral face of the device. The tubes furthermore have a perimetral edge in the form of a flat lateral band; the function of the perimetral edge is to make manufacturing and stacking the boards (7) easier, limiting possible relative movements in any direction of their main plane and simplifying their assembly as they serve as a guide in contact with the shell (8) that will be identified below.

In one embodiment (not shown in the drawings), the tubes of the second tube bundle (6) have a flat and straight configuration, without the fluid changing direction. In an alternative embodiment, the tubes of the second tube bundle (6) are arranged in the same direction as the tubes of the first tube bundle (3). In another alternative embodiment, the tubes of the second tube bundle (6) are arranged transverse to the tubes of the first tube bundle (3).

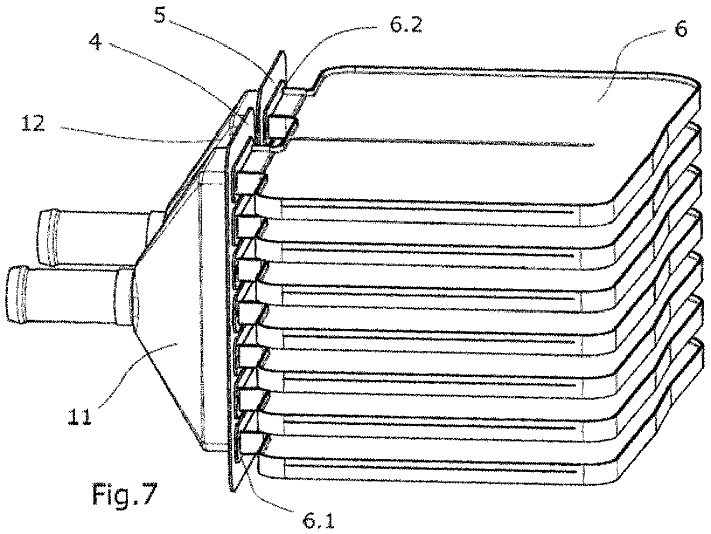

Figure 7 shows the second tube bundle (6) forming a stack and with the ends of the inlets and outlet showing the support elements (6.1, 6.2) supported on the second baffles (4, 5). The same conditions of attachment between the tubes (3) and the baffles (1, 2) of the first assembly are verified for the attachment between the tubes of the second tube bundle (6) and the second baffles (4, 5).

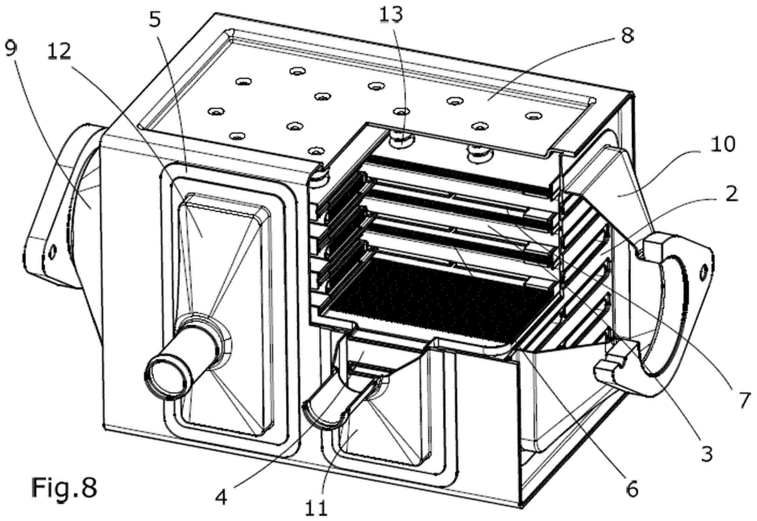

Figure 8 shows a view of the recuperator for recovering energy with a quarter section at the top which allows showing on one hand the stack of tubes (3, 6) and on the other the shell (8). The purpose of the shell (8) is to protect and hold the assembly of the recuperator for recovering energy. Furthermore, the shell (8) allows placing an assembly of springs (13) between the stack of tubes (3, 6) and the shell (8); these springs (13) have the function of producing a compressive stress in the stacking direction.

According to a preferred way of carrying out the construction method for constructing the recuperator for recovering energy, support elements (3.1, 3.2, 6.1, 6.2) are first provided at the ends of the tubes (3, 6); as described above, the way of constructing these support elements (3.1, 3.2, 6.1, 6.2) depends on the type of tubes (3, 6) and on the type of support elements (3.1, 3.2, 6.1, 6.2) themselves. In one embodiment of the device like the one shown in the drawings in which the tubes (3, 6) are flat and the support elements (3.1, 3.2, 6.1, 6.2) are transverse plates, the support elements (3.1, 3.2, 6.1, 6.2) are welded to the ends of the tubes (3, 6).

Alternatively, the support elements (3.1, 3.2, 6.1, 6.2) can be constructed by means of stamping the elements making up the flat tubes (3, 6), and subsequently bending the support elements (3.1, 3.2, 6.1, 6.2) such that they form a suitable support surface.

Secondly, the tubes (3, 6) and the boards (7) comprising the thermoelectric modules (7.1) are stacked. Although it is possible, in principle, to construct the device with independent thermoelectric modules (7.1), it is more convenient to group them together on boards (7) and to stack these boards. The way of stacking the tubes (3, 6) and the boards (7) must allow the first faces (7.1.1) of the thermoelectric modules (7.1) to be in thermal contact with the surface of the first tubes (3), and the second faces (7.1.2) of the thermoelectric modules (7.1) to be in thermal contact with the surface of the second tubes (6). The orientation of the faces (7.1.1, 7.1.2) and the name thereof depends on the polarity of the thermoelectric modules (7.1); for the sake of clarity it will be considered that the first faces (7.1.1) correspond to the hot source, and the second faces (7.1.2) correspond to the hot source and the chosen orientation of the boards (7) is such that the face intended for being in contact with the hot source corresponds to the tube with the hot gas and the face intended for being in contact with the cold source corresponds to the tube with the liquid coolant.

A favorable way of making the stack according to what has been described is as follows:

- firstly, arranging a tube of the second tube bundle (6),
- then arranging a board (7), with the second faces (7.1.2) in contact with the tube (6) for the liquid coolant,
- arranging a tube of the first tube bundle (3), with the first faces (7.1.1) in contact with the tube (3) for the hot gas,
- then arranging another board (7), with the first faces (7.1.1) in contact with the tube (3) for the hot gas,
- arranging another tube of the second tube bundle (6), with the second faces (7.1.2) in contact with the tube (6) for the liquid coolant, and
- repeating the preceding steps.

A stack of the desired size can thereby be formed depending on the number of tubes of the first tube bundle (3) the recuperator for recovering energy has. An example of stack following the described order (the thermoelectric boards (7) are not visible in this drawing) with six tubes of the first tube bundle (3) and twelve thermoelectric boards (7) can be seen in Figure 2. To maintain the temperature gradient between the first faces (7.1.1) and the second faces (7.1.2) of the thermoelectric modules (7.1), according to one embodiment, a layer of insulating material is included on the surfaces of thermal contact between the boards (7) and the tubes (3, 6). This layer of insulating material must allow a certain degree of heat transfer by conduction, graphite (14.1) (in contact with the hot side, or first face) and silicone derivatives (14.2) (in contact with the cold side, or second face) being materials suitable for this use. In this manner, only part of the heat generated in the tubes of the first tube bundle (3) is transferred to the first faces (7.1.1) through the insulating layer, preventing thermal equilibrium with the second faces (7.1.2) from being reached.

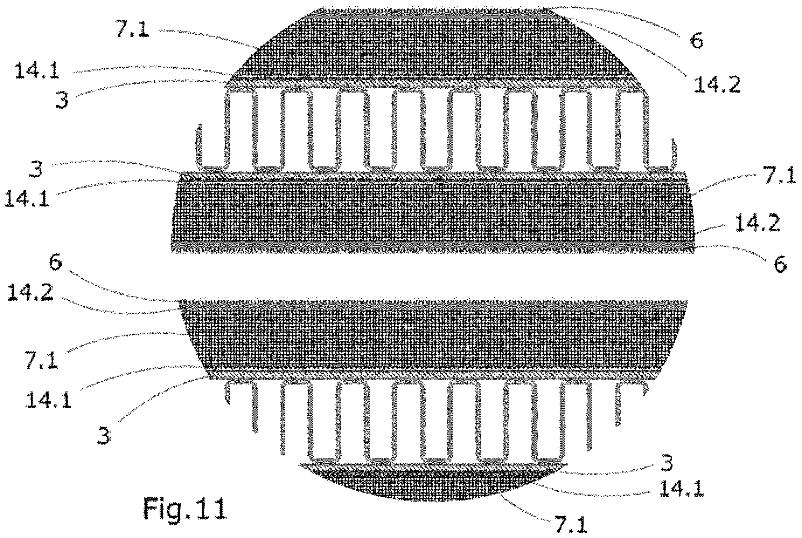

Figure 11 shows the particular arrangement of the elements forming the stack according to the embodiment described above. According to the shown embodiment, between a tube of the first tube bundle (3) and a thermoelectric module (7.1) one or more layers of graphite (14.1) are arranged in thermal contact with the first face (7.1.1) of a thermoelectric module (7.1) and with the tube (3), whereas between a tube of the second tube bundle (6) and a thermoelectric module (7.1) one or more layers of silicone (14.2) are arranged in thermal contact with the second face (7.1.2) of a thermoelectric module (7.1) and with the tube (6).

If graphite (14.1) is used, it will be supplied in the form of a sheet. When the insulating material is a silicone derivative (14.2), the material is applied in the form of a fluid or pasty substance which allows a closer contact between the surfaces between which said material is applied and allows homogenizing the temperature in the contact region of the cold side between the boards (7) and the tubes (3, 6).

As part of the stacking step, the tubes of both tube bundles (3, 6) must be arranged such that the support elements (3.1, 3.2, 6.1, 6.2) are supported on the corresponding baffles (1, 2, 4, 5).

In one embodiment, as part of the stacking step, one or more layers of silicone (14.2) are arranged between a tube of the second tube bundle (6) and the second face (7.1.2) of a board (7). Similarly, in one embodiment, as part of the stacking step, one or more graphite sheets (14.1) are arranged between the first face (7.1.1) of a board (7) and a tube of the first tube bundle (3) for the hot gas.

Given the configuration of the support elements (3.1, 3.2, 6.1, 6.2), the plurality of said support elements which are supported on one and the same baffle configure a flat fragmented surface which is supported on said also flat baffle.

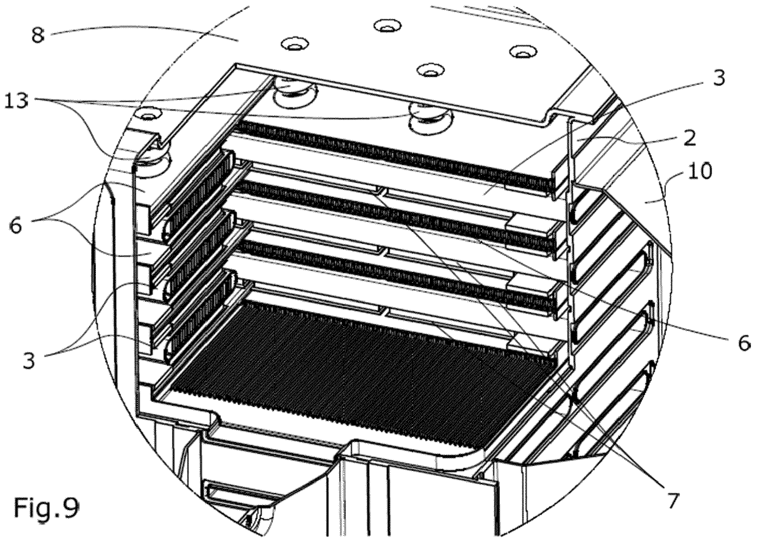

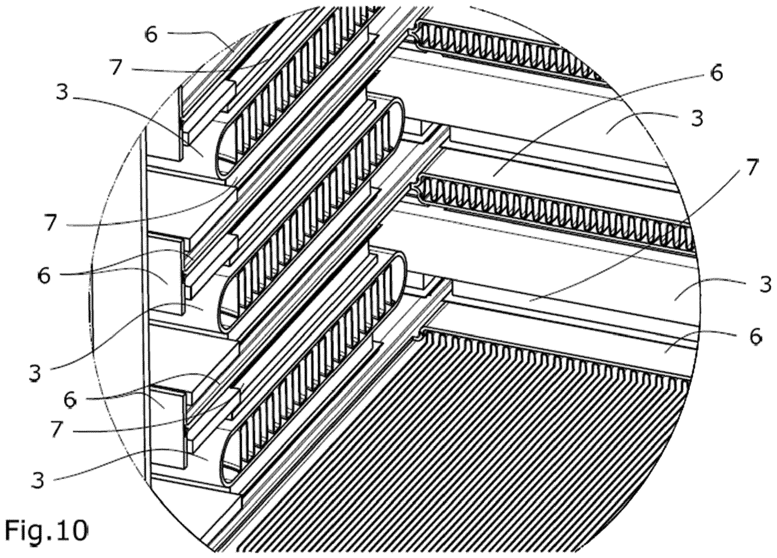

In this step, the contact between the support elements (3.1, 3.2, 6.1, 6.2) and the baffles (1, 2, 4, 5) must be a sliding contact according to the stacking direction, allowing movements of the support elements (3.1, 3.2, 6.1, 6.2) in the stacking direction and maintaining contact with the baffles (1, 2, 4, 5). Furthermore, it is important that the position of the baffles (1, 2, 4, 5) and the stacked tubes (3, 6) allows for fluid communication between the manifolds (9, 10, 11, 12); to that end, the openings of the baffles (1, 2, 4, 5) must be aligned with the openings of the conduits of the tubes (3, 6); Figures 9 and 10 show this configuration. Given that there is possibility that sliding occurs, the openings of the baffles (1, 2, 4, 5) must be large enough so as to assure that the ends of the tubes open into said openings even with the expected movements.

In a last step of the construction method, the attachments between the support elements (3.1, 3.2, 6.1, 6.2) and the baffles (1, 2, 4, 5) are fixed. In a way of carrying out the invention, this attachment constitutes laser welding which immobilizes the ends of the tubes and assures the leaktightness between the attached elements. To assure a better thermal contact between the thermoelectric modules (7.1) and the tubes (3, 6), the present invention proposes fixing the attachment between the support elements (3.1, 3.2, 6.1, 6.2) and the baffles (1, 2, 4, 5) while applying a compressive stress according to the stacking direction, where the welded attachment is therefore able to maintain the contact pressure and to provide an excellent thermal contact of the thermoelectric modules (7.1) with the tubes (3, 6).

**Claims**

1. A recuperator for recovering energy from exhaust gas heat of an internal combustion engine, there being a first hot fluid, i.e., the exhaust gas, and a second cold fluid, i.e., a liquid coolant, wherein the recuperator comprises:

   - at least a first inlet baffle (1) and a first outlet baffle (2) for the first fluid and a second inlet baffle (4) and a second outlet baffle (5) for the second fluid, wherein each of the baffles (1, 2, 4, 5) comprises openings for the passage of the corresponding fluid;
   - a first tube bundle (3) for the passage of the first fluid, wherein these tubes (3):

        are arranged essentially parallel to one another and,
        the tubes (3) of the first tube bundle (3) extend from the first inlet baffle (1) to the first outlet baffle (2);

   - a second tube bundle (6) for the passage of the second fluid, wherein these tubes (6):

        are arranged essentially parallel to one another and,
        the tubes (6) of the second tube bundle (6) extend from the second inlet baffle (4) to the second outlet baffle (5) ;

   - a plurality of thermoelectric modules (7.1) comprising a first face (7.1.1) and a second face (7.1.2) arranged opposite the first face (7.1.1), wherein the thermoelectric modules (7.1) are adapted for generating an electric potential based on a temperature gradient between the first face (7.1.1) and the second face (7.1.2);

   wherein the first tube bundle (3), the second tube bundle (6) and the plurality of thermoelectric modules (7.1) form a stack such that each thermoelectric module (7.1) has the first face (7.1.1) in thermal contact with a tube (3) of the first tube bundle (3) the second face (7.1.2) in thermal contact with a tube (6) of the second tube bundle (6);
   **characterized in that**
   the tubes (3) of the first tube bundle (3), the tubes (6) of the second tube bundle (6), or both (3, 6), comprise a support element (3.1, 3.2, 6.1, 6.2) at each end of the tube (3, 6) adapted for being supported on a face of the baffle (1, 2, 4, 5) corresponding to said end of the tube (3, 6) and establishing a fluid communication through one or more openings of the baffle (1, 2, 4, 5) between the inside of the tube (3, 6) and the side of the baffle (1, 2, 4, 5) arranged on the side opposite the tube (3, 6).

2. The recuperator according to the preceding claim, wherein there is a leak-tight attachment between each support element (3.1, 3.2, 6.1, 6.2) and the baffle (1, 2, 4, 5) on which it is supported.

3. The recuperator according to any of the preceding claims, wherein the support element (3.1, 3.2, 6.1, 6.2) is an element extending perimetrically around the tube.

4. The recuperator according to any of the preceding claims, wherein said recuperator comprises a shell (8).

5. The recuperator according to any of the preceding claims, wherein said recuperator comprises a plurality of springs (13) arranged between the shell (8) and the stack and are adapted for applying a compressive force on said stack.

6. The recuperator according to any of the preceding claims, wherein:

   - either the tubes (3) of the first tube bundle (3) have a longitudinal configuration and the tubes (6) of the second tube bundle (6) have a U-shaped configuration;
   - or the tubes (6) of the second tube bundle (6) have a longitudinal configuration and the tubes (3) of the first tube bundle (3) have a U-shaped configuration.

7. The recuperator according to any of the preceding claims, wherein the tubes (3) of the first tube bundle (3) are transverse to the tubes (6) of the second tube bundle (6).

8. The recuperator according to any of the preceding claims, wherein the tubes (3) of the first tube bundle (3) or the tubes (6) of the second tube bundle (6) or both are flat.

9. The recuperator according to any of the preceding claims, wherein the tubes (3) of the first tube bundle (3) are arranged as double tubes in the stack to increase the contact area with the thermoelectric module or modules (7.1).

10. The recuperator according to any of the preceding claims, wherein there is a thermal insulation material between a thermoelectric module (7.1) and the tube (3, 6) with which it is in thermal contact.

11. The recuperator according to claim 10, wherein the thermal insulation material between the thermoelectric module (7.1) and the tube (3) of the first tube bundle (3) is graphite (14.1).

12. The recuperator according to claim 10, wherein the thermal insulation material between the thermoelectric module (7.1) and the tube (6) of the second tube bundle (6) is silicone (14.2).

13. The recuperator according to any of the preceding claims, wherein a plurality of thermoelectric modules (7.1) in the stack are grouped together on a board (7) having a flat configuration.

14. The recuperator for recovering heat according to any of the preceding claims, wherein one or more baffles (1, 2, 4, 5) are attached to a manifold.

15. The recuperator for recovering heat according to any of the preceding claims, wherein the support element (3.1, 3.2, 6.1, 6.2) is a plate transverse to the tube (3, 6).

16. The recuperator for recovering heat according to the preceding claim, wherein the plate transverse to the tube (3, 6) is a prolongation of the tube (3, 6).

17. A construction method for constructing a recuperator for recovering energy from exhaust gas heat of an internal combustion engine, there being a first hot fluid, i.e., the exhaust gas, and a second cold fluid, i.e., a liquid coolant, wherein the recuperator comprises:

   - at least a first inlet baffle (1) and a first outlet baffle (2) for the first fluid and a second inlet baffle (4) and a second outlet baffle (5) for the second fluid, wherein each of the baffles (1, 2, 4, 5) comprises openings for the passage of a fluid;
   - a first tube bundle (3) for the passage of the first fluid, wherein these tubes (3):

     are arranged essentially parallel to one another and,
     the tubes (3) of the first tube bundle (3) extend from the first inlet baffle (1) to the first outlet baffle (2);

   - a second tube bundle (6) for the passage of the second fluid, wherein these tubes (6):

     are arranged essentially parallel to one another and,
     the tubes (6) of the second tube bundle (6) extend from the second inlet baffle (4) to the second outlet baffle (5) ;

   - a plurality of thermoelectric modules (7.1) comprising a first face (7.1.1) and a second face (7.1.2) arranged opposite the first face (7.1.1), wherein the thermoelectric modules (7.1) are adapted for generating an electric potential based on a temperature gradient between the first face (7.1.1) and the second face (7.1.2);

   wherein the method comprises the following steps:

     a) providing a support element (3.1, 3.2, 6.1, 6.2) at each end of the tube (3, 6) adapted for being supported on a face of the baffle (1, 2, 4, 5) corresponding to said end of the tube (3, 6);
b) establishing a stack of the first tube bundle (3), the second tube bundle (6) and the plurality of thermoelectric modules (7.1) such that

    - each thermoelectric module (7.1) has the first face (7.1.1) in thermal contact with a tube (3) of the first tube bundle (3), the second face (7.1.2) in thermal contact with a tube (6) of the second tube bundle (6) and,
    - the support elements (3.1, 3.2, 6.1, 6.2) are supported on the baffles (1, 2, 4, 5) corresponding to each end of the tube (3, 6), establishing fluid communication through one or more openings of the baffle (1, 2, 4, 5) between the inside of the tube (3, 6) and the side of the baffle (1, 2, 4, 5) arranged on the side opposite the tube (3, 6);

c) attaching each of the support elements (3.1, 3.2, 6.1, 6.2) to the baffle (1, 2, 4, 5) on which it is supported.

Fig. 1

Fig.2

Fig.3

Fig. 4

Fig.5

Fig.6

EP 3 505 859 A1

Fig.7

18

Fig.8

Fig.9

Fig.10

Fig.11

**Europäisches Patentamt**
**European Patent Office**
**Office européen des brevets**

## EUROPEAN SEARCH REPORT

Application Number

EP 17 38 2903

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2014/182647 A1 (GILLE GERARD [FR] ET AL) 3 July 2014 (2014-07-03) * the whole document * | 1-17 | INV. F28D21/00 F28D7/16 F28D9/00 F01N5/02 F28F9/04 |
| X | DE 10 2012 206127 A1 (BEHR GMBH & CO KG [DE]) 17 October 2013 (2013-10-17) * the whole document * | 1-17 | |
| A | EP 3 193 120 A1 (BORGWARNER EMISSIONS SYSTEMS SPAIN SLU [ES]) 19 July 2017 (2017-07-19) * abstract; figures 1-9 * | 1,16 | |
| A | US 2014/047822 A1 (OESTERLE JOERG [DE] ET AL) 20 February 2014 (2014-02-20) * paragraph [0038] - paragraph [0043]; figure 2 * | 10-12 | |

TECHNICAL FIELDS SEARCHED (IPC)

F28D
F01N
F28F

The present search report has been drawn up for all claims

| Place of search | Date of completion of the search | Examiner |
|---|---|---|
| Munich | 30 May 2018 | Bloch, Gregor |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 17 38 2903

This annex lists the patent family members relating to the patent documents cited in the above-mentioned European search report.
The members are as contained in the European Patent Office EDP file on
The European Patent Office is in no way liable for these particulars which are merely given for the purpose of information.

30-05-2018

| Patent document cited in search report | | Publication date | Patent family member(s) | | Publication date |
|---|---|---|---|---|---|
| US 2014182647 | A1 | 03-07-2014 | EP | 2727158 A1 | 07-05-2014 |
| | | | FR | 2977373 A1 | 04-01-2013 |
| | | | JP | 2014529178 A | 30-10-2014 |
| | | | US | 2014182647 A1 | 03-07-2014 |
| | | | WO | 2013001016 A1 | 03-01-2013 |
| DE 102012206127 | A1 | 17-10-2013 | NONE | | |
| EP 3193120 | A1 | 19-07-2017 | CN | 106968843 A | 21-07-2017 |
| | | | EP | 3193120 A1 | 19-07-2017 |
| | | | KR | 20170085453 A | 24-07-2017 |
| | | | US | 2017205153 A1 | 20-07-2017 |
| US 2014047822 | A1 | 20-02-2014 | CN | 103628955 A | 12-03-2014 |
| | | | DE | 102012214759 B3 | 06-02-2014 |
| | | | EP | 2700795 A1 | 26-02-2014 |
| | | | JP | 5594676 B2 | 24-09-2014 |
| | | | JP | 2014040235 A | 06-03-2014 |
| | | | US | 2014047822 A1 | 20-02-2014 |

EPO FORM P0459

For more details about this annex : see Official Journal of the European Patent Office, No. 12/82